# EUROPEAN PATENT SPECIFICATION

(11) **EP 2 401 896 B1**
(45) Date of publication and mention of the grant of the patent: **21.10.2015**
(21) Application number: 09840870.1
(22) Date of filing: 17.09.2009
(51) Int. Cl.: H05H 1/24, H01J 37/32

(54) **ATMOSPHERIC LOW-TEMPERATURE MICRO PLASMA JET DEVICE FOR BIO-MEDICAL APPLICATION**
ATMOSPHÄRISCHE NIEDERTEMPERATUR-MIKROPLASMAJETANORDNUNG FÜR BIOMEDIZINISCHE ANWENDUNG
DISPOSITIF À MICRO-JETS DE PLASMA ATMOSPHÉRIQUE À BASSE TEMPÉRATURE POUR APPLICATION BIOMÉDICALE

(30) Priority: 27.02.2009 KR 20090016663; 02.04.2009 KR 20090028661
(43) Date of publication of application: 04.01.2012
(73) Proprietor: Ajou University Industry Cooperation Foundation, Suwon-si, Gyeonggi-do 443-749 (KR)
(72) Inventor: YANG, Sang Sik, Seoul 137-825 (KR); KIM, Kang il, Jeonju-si Jeollabuk-do 560-779 (KR); KIM, Geun young, Suwon-si Gyeonggi-do 442-180 (KR)
(74) Representative: Kuhnen & Wacker
(86) International application number: PCT/KR2009/005282
(87) International publication number: WO 2010/098524

(56) References cited:
- EP-A1- 0 790 757
- EP-A2- 1 950 528
- WO-A1-00/79843
- WO-A2-2007/067924
- JP-A- 11 329 334
- US-A- 4 507 181
- US-A- 5 637 539
- US-A1- 2003 215 983
- US-A1- 2003 223 103
- US-A1- 2004 116 752
- US-A1- 2008 152 839
- US-B1- 6 980 629
- US-B1- 7 127 301
- US-B2- 6 943 316
- HONG ET AL.: "Microplasma jet at atmospheric pressure", APPLIED PHYSICS LETTERS, vol. 89, no. 22, 27 November 2006 (2006-11-27), pages 221504-1-221504-3, XP002693216, USA ISSN: 0003-6951, DOI: 10.1063/1.2400078

## Description

### TECHNICAL FIELD

The present invention relates to an atmospheric low-temperature micro plasma jet device for bio-medical application, and more particularly, to a plasma jet device manufactured by using a micromachining process such as microelectromechanical systems (MEMS) in such a way that the diameter of micro electrodes jetting plasma is less than several tens micrometers, thereby generating and jetting low-temperature plasma with a high current density using a low voltage under atmospheric pressure, which is capable of being applied in the field of bio-medical.

### BACKGROUND ART

From prior art document US 2003/0223103 A1 there is known a method for manufacturing electrodes on a substrate. The method comprises the step of depositing an insulating layer on the substrate, depositing a Ti/Cu seed layer on the insulating layer, to form a photoresist on the seed layer, patterning the photoresist layer, forming an electrode layer by plating thereon and removing the photoresist layer.

From prior art document US 5,637,539 A there is known a fabrication process for vacuum microelectronic devices having multiple electrode levels, wherein an electrode layer formed in a trench is planarized by mechanical polishing.

From prior art document EP 0 790 757 A1 there is known a fast atomic beam (FAB) source which is capable of generating fast atomic beams having characteristics of a high beam density, a precise directionality, and a wide range of controlled output energy levels. The FAB source is comprised of a discharge tube, an inductively coupled plasma generator for generating gas plasma in the discharge tube from introduced gas therein, positive and negative electrodes for accelerating ions to control the beam for a variety of energy levels. The negative electrode has a beam control opening for generating a FAB, wherein directionability, neutralization factor and other FAB characteristics are controlled.

From the article "Microplasma jet at atmospheric pressure" by Yong Cheol Hong and Han Sup Uhm in Applied Physics Letters, Bd. 89, 221504 (2006) there is known an apparatus for generating a microplasma jet at atmospheric pressure.

From WO 00/79843 A1 there is known a plasma treatment apparatus comprising an electrode used as an anode, configured to eject plasma through holes in it, a gas injection pipe injecting gas from the outside and an insulating case surrounding the electrode.

From WO 2007/067924 A2 there is known a method for manufacturing an electrode of a plasma jet device.

Plasma has been applied to various fields such as semiconductor industry, display industry, and surface modification of materials. As plasma technology has been more and more developed, researches for applying plasma to the medical field is proceeding. Plasma may be divided into high-temperature plasma and low-temperature plasma. When using high-temperature plasma for medical purpose there is a thermal damage on a cell. Accordingly, it is required to use a glow discharge that is low-temperature plasma, for medical purpose. Since a glow discharge is very unstable under atmospheric pressure, the glow discharge is easy to be transited into an arc discharge that is high-temperature plasma.

To prevent glow to arc transition (GAT), heating on an electrode has to be prevented while a discharge occurs. In a way where a discharge occurs while gas continuously flows in, an electrode is naturally cooled, thereby generating a glow discharge stable under atmospheric pressure. There has been reported research on generating a discharge using a pipe or needle, mechanically processed, to generate a stable glow discharge under atmospheric pressure. However, there is a limitation on reducing a size via mechanical processing and it is difficult to process a broad area.

### DETAILED DESCRIPTION OF THE INVENTION

### TECHNICAL PROBLEM

The object of the present invention is to provide a plasma jet device for generating a microplasma jet at atmospheric pressure and low temperature. Further, it is an object of the invention to provide a method for manufacturing an electrode for such plasma jet device.

### TECHNICAL SOLUTION

The object of the invention is attained by a plasma jet device according to claim 1 and by a method of manufacturing an electrode for such plasma jet device according to claim 6. Further developments of the invention are characterized in the dependent claims.

### ADVANTAGEOUS EFFECTS

As described above, a plasma jet device according to an embodiment of the present invention is manufactured by using a micromachining process such as microelectromechanical systems (MEMS) in such a way that a diameter of micro electrodes where plasma is jetted is several micro meters or less, thereby generating and jetting low-temperature plasma with a high current density using a low voltage under atmospheric pressure.

Also, since capable of jetting low-temperature micro plasma, the plasma jet device may be applied to the field of bio-medical using apoptosis.

### BRIEF DESCRIPTION OF THE DRAWINGS

FIG. 1 is a diagram illustrating a plasma jet device according to an embodiment of the present invention;
FIG. 2 is a cross-sectional view illustrating the plasma jet device of FIG. 1;
FIG. 3 is a flowchart illustrating a process of manufacturing an electrode of the plasma jet device of FIG. 1 using micromachining technology;
FIG. 4 is a diagram illustrating an example of an electrode manufactured according to the process of FIG. 3;
FIG. 5 is a graph illustrating a discharge firing voltage according to a gas flow rate in the plasma jet device of FIG. 1; and
FIG. 6 is a graph illustrating discharge voltage/current characteristics according to a gas flow rate in the plasma jet device of FIG. 1.

### BEST MODE FOR CARRYING OUT THE INVENTION

To fully understand advantages of operations of the present invention and the objects obtained by embodiments of the present invention, it is required to refer to attached drawings illustrating preferable embodiments of the present invention and contents shown in the drawings. Hereinafter, the preferable embodiments of the present invention will be described in detail with reference to the attached drawings. The same reference numerals shown in each drawing indicate the same elements.

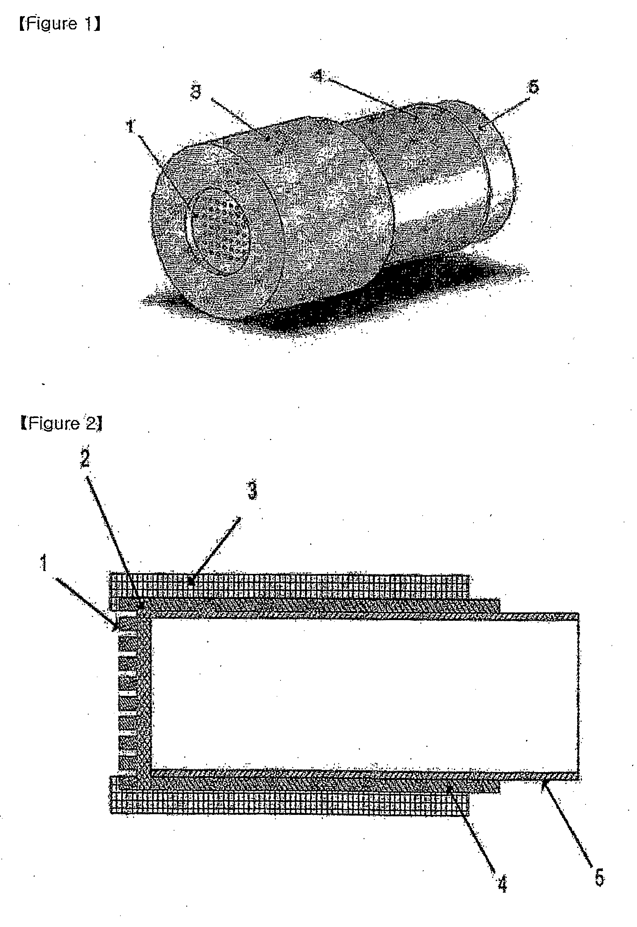

FIG. is a diagram illustrating a plasma jet device according to an embodiment of the present invention. FIG. 2 is a cross-sectional view illustrating the plasma jet device of FIG. 1. The plasma jet device includes an electrode 1 used as an anode, a gas injection pipe 5 used as a cathode, a porous insulating material 2, a protection pipe 4, and an insulating case 3. There are a plurality of holes formed in the electrode 1, through which plasma generated by a discharge between the electrode 1 and the gas injection pipe 5 is jetted. On the other hand, in the present embodiment, the electrode 1 is formed of a metal, and more preferably, formed of nickel. The gas injection pipe 5 injects gas from the outside. In the present embodiment, the gas injection pipe 5 may be formed of stainless steel. The porous insulating material 2 is disposed between the electrode 1 and the gas injection pipe 5 and insulates the electrode 1 from the gas injection pipe 5. Also, the porous insulating material 2 allows the gas injected by the gas injection pipe 5 to be transported to the electrode 1 and may have a plurality of tubes and holes for this. In the present embodiment, the porous insulating material 2 may be formed of a ceramic material, and more preferably, formed of an alumina material.

The protection pipe 4 surrounds the gas injection pipe 5, thereby insulating and protecting the gas injection pipe 5 from the outside. In the present embodiment, the protection pipe 4 may be formed of a ceramic material, for example, quartz. The insulating case 3 surrounds one of the electrode 1, the porous insulating material 2, and the gas injection pipe 5, which is connected to the porous insulating material 2.(surrounds the porous insulating material 2 which the electrode 1 and the gas injection pipe 5 connect.) A discharge occurs between the electrode 1 and the gas injection pipe 5 to generate plasma. The insulating case 3 prevents such discharge from being diffused outside.

A theory of generating and jetting plasma in the plasma jet device is as follows. Gas flowing through the gas injection pipe 5 is ionized by an electric field formed between the holes of the electrode 1 and the gas injection pipe 5 while passing through the porous insulating material 2, thereby generating plasma. The plasma formed as described above is pushed out by gas injected by the gas injection pipe 5 and jetted via the holes of the electrode 1.

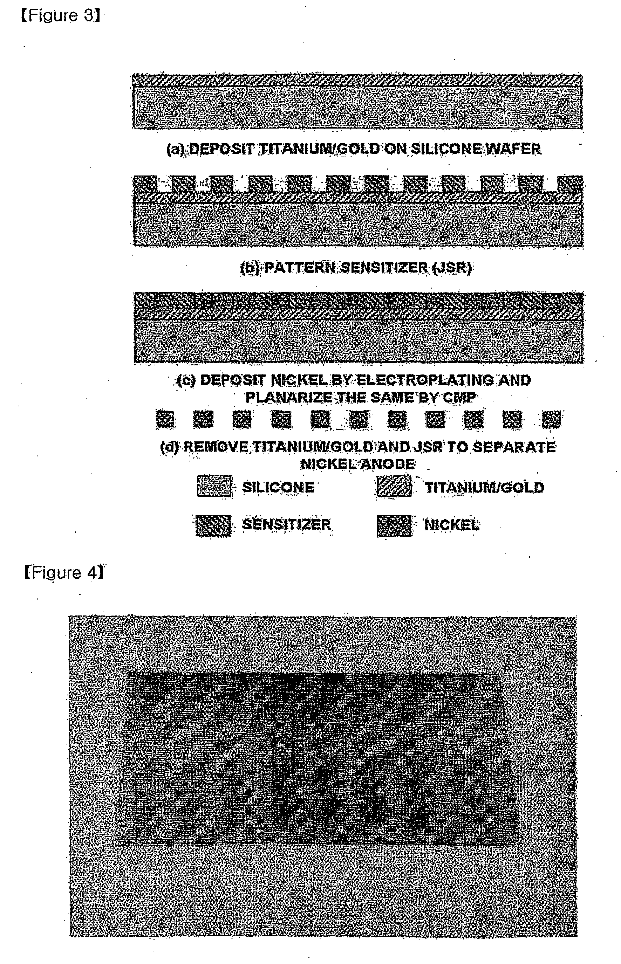

Hereinafter, referring to FIGS. 3 and 4, a process of manufacturing the electrode 1 of the plasma jet device of FIG. 1 will be described. FIG. 3 is a flowchart illustrating a process of manufacturing the electrode 1 of the plasma jet device of FIG. 1 using micromachining technology, and FIG. 4 is a diagram illustrating an example of an electrode manufactured by the process of FIG. 3.

Referring to FIG. 3(a), a seed layer is formed on a board. In the present embodiment, the board may be a silicone wafer. On the other hand, the seed layer may be formed by sputtering titanium/gold to be deposited. After forming the seed layer, a mold layer is formed on the seed layer. The mold layer will be used as a mold for electroplating to form an electrode layer that will be described later. In the present embodiment, the mold layer may be formed by coating the board with JSR that is a negative sensitizer. Also, the mold layer may be formed with a thickness of 100 *µ*m or less. After forming the mold layer, the mold layer is patterned to form a plurality of electrode hole forming portions thereon. The electrode layer that will be described later is formed on the electrode hole forming portions. In this case, a width of the electrode hole forming portions, such as a diameter of a cross-section thereof, may be 100 *µ*m or less. Also, the number of the electrode hole forming portions may be 10×10 or more in the electrode 1.

On the other hand, as shown in (b) of FIG. 3, in the present embodiment, the mold layer is formed corresponding to the holes of the electrode 1 shown in FIG. 1. In this case, the mold layer may be patterned in such a way that the plurality of electrode hole forming portions are separated from one another with the same interval. Also, the mold layer may be patterned in such a way that holes corresponding to the patterned mold layer are separated from one another with several tens *µ*m.

After patterning the mold layer, as shown in (c) of FIG. 3, an electrode layer is formed on the board where the patterned mold layer is formed. In the present embodiment, the electrode layer may be formed by electroplating a metal. The electroplated metal may be nickel. Also, a thickness of a nickel layer formed on the electrode hole forming portions may be 70 *µ*m or less. After forming the electrode layer, the patterned mold layer and the electrode layer are planarized and, as shown in (d) of FIG. 3, the board, the seed layer, and the patterned mold layer are removed, thereby forming the electrode 1 (referring to FIG. 4). In the present embodiment, planarization may be performed by chemical mechanical polishing. A thickness of the planarized electrode layer may be 60 *µ*m or less. On the other hand, the plasma jet device according to an embodiment of the present invention may be used in the bio-medical field, and more particularly, for cure diseases by inducing apoptosis.

There are two methods of the death of cells, such as necrosis and apoptosis. The necrosis is a way that a cell is dead due to an external shock without its intention. Since the cell bursts and contaminates peripheral cells in this case, the necrosis is not effective as a medical treatment. On the other hand, the apoptosis is a way that a cell kills itself. In this case, the cell does not contaminate peripheral cells in such a way that a problem of the necrosis does not occur. Via researches in the bio-medical filed, it is known that the cell kills itself when treating a cell by using plasma, that is, plasma is irradiated to the cell.

The plasma jet device according to an embodiment of the present invention may be used for a medical treatment using the apoptosis by using such phenomenon. That is, the plasma jet device may be used for the purpose of treating diseases by jetting generated plasma to cells to be dead, such as cancer cells.

### Embodiment 1: Forming a nickel anode as an electrode

A process of manufacturing a nickel anode was as follows. Titanium and gold, which would be seed layers, were deposited on a silicone board with 500 A and 2500 A. SU8-2100 that was a thick negative sensitizer was patterned to a thickness of 100 *µ*m and used as a plating mold. Nickel plating employed nickel sulfamate baths. The nickel sulfamate baths was composed of 450 g/L of nickel sulfate [Ni(NH2SO3)24H2O], 30 g/L of boric acid added to reduce the stress of nickel, and 5 g/L of a humectant such as dodecyl sulfate sodium salt wetter to increase the quality of plated nickel. A nickel layer with a thickness of 70 *µ*m was formed by plating for 80 hours at a current density of 1.3 mA/cm2. To planarize the manufactured nickel layer, the thickness of the nickel layer was reduced to 60 *µ*m by chemical mechanical polishing (CMP) process. To separate the manufactured nickel layer, the silicone board was removed and SU8-2100 used as a mold was removed, thereby forming an anode.

### Embodiment 2: Manufacturing a plasma jet device

A plasma jet device included an anode, through which plasma was jetted, a dielectric layer insulating the anode from a cathode, and the cathode, into which gas flowed. The anode was manufactured using nickel and a thickness thereof was 60 *µ*m. A diameter of a hole, through which plasma was jetted, was 100 *µ*m and a number thereof was 10×10. The dielectric layer was manufactured using porous alumina capable of insulating the anode from the cathode simultaneously with allowing the gas to pass. A thickness of the dielectric layer between the anode and the cathode was 1 mm. As the cathode, there was used a stainless steel tube with an external diameter of 1.6 mm and an internal diameter of 1.2 mm. For the sake of safety during a discharge experiment, the cathode was put into a quartz tube to be insulated from the surroundings thereof.

### Experimental example 1: Discharge firing voltage

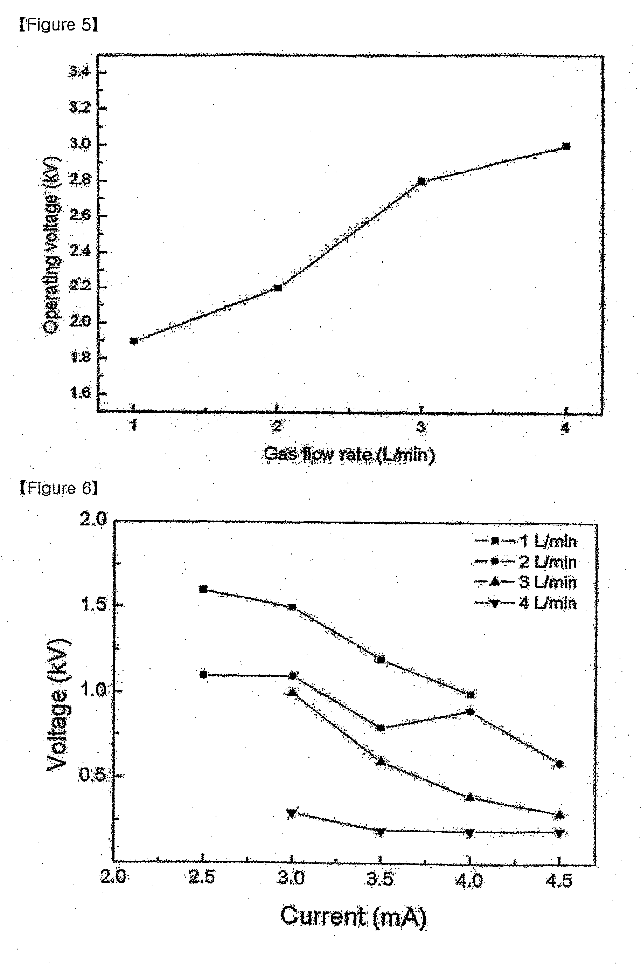

An experiment of discharge was performed by using a nitrogen gas with a direct current (DC) under atmospheric pressure. A safety resistor of 2 MΩ was used and a voltage of 0 V to 9 kV was applied. To examine an effect of the flow rate of gas upon a discharge firing voltage, discharge characteristics depending on the flow rate were observed. A temperature of plasma was measured to examine whether being applied to bio-medical field. To measure a discharge firing voltage and current and voltage characteristics according to the flow rate of gas, a case where the flow rate of the nitrogen gas was to 4 L/min was experimented. FIG. 5 is a graph illustrating a discharge firing voltage according to a gas flow rate in the plasma jet device of FIG. 1. Referring to FIG. 5, it can be known that the discharge firing voltage of the plasma jet device increases when increasing the gas flow rate. The shorter time that the gas stays in an electric field, the high voltage required for discharge firing.

### Experimental example 2: Discharge voltage and current characteristics

FIG. 6 is a graph illustrating discharge voltage/current characteristics according to a gas flow rate in the plasma jet device of FIG. 1. When a discharge starts, a current rises and a voltage drops. To measure a temperature of jetted plasma, a temperature was measured while jetting plasma to a thin aluminum layer for 10 minutes. As a result of measurement, it was checked that the highest temperature of the jetted plasma was 41 °C. Since the time of processing plasma, required in bio-medical field, is 10 seconds or so, it is regarded as a thermal damage of a cell, caused by the plasma, does not occur. In the present embodiment, a device capable of jetting micro plasma under atmospheric pressure was manufactured. The manufactured device successfully jetted plasma under atmospheric pressure. Also, a discharge firing voltage of the device, according to a gas flow rate, was measured and it could be known that the smaller flow rate, the more discharge firing voltage dropped. Since the highest temperature of the jetted plasma is 41 °C, it is regarded as there is no damage on a cell when being applied to the bio-medical field. Hereafter, when optimizing a design of both holes and a thickness of a dielectric layer, it is expected that the atmospheric pressure plasma jet device is capable of being applied to the bio-medical field. As described above, exemplary embodiments have been shown and described. Though specific terms are used herein, they are just used for describing the present invention but do not limit the scope of the present invention as disclosed in the claims. Therefore, it would be appreciated by those skilled in the art that changes may be made to these embodiments without departing from the technical scope of the present invention a defined by the claims and their equivalents.

### INDUSTRIAL APPLICABILITY

The present invention may be applied to the field of bio-medical.

## Claims

1. A plasma jet device comprising:
an electrode (1) used as an anode, wherein the electrode is configured to eject plasma through holes in it;
a gas injection pipe (5) injecting gas from the outside; and
an insulating case (3);
**characterized in that** the gas injection pipe (5) is used as a cathode and **in that** the plasma jet device further comprises:
a protection pipe (4) surrounding the gas injection pipe (5) to protect the gas injection pipe (5) from the outside; and
a porous insulating material (2) disposed between said electrode (1) and the gas injection pipe (5) and insulating the electrode (1) from the gas injection pipe (5) and having a plurality of passing holes to allow the gas injected by the gas injection pipe (5) to be transferred to the electrode,
wherein the insulating case (3) surrounds one of the electrode (1), the porous insulating material (2), and the gas injection pipe (5), and
wherein the insulating case (3) is connected to the porous insulating material (2) and prevents the diffusion of a discharge occurring between the electrode (1) and the gas injection pipe (5) to generate the plasma.

2. The plasma jet device of claim 1, wherein the gas injection pipe (5) is formed of stainless steel.

3. The plasma jet device of claim 1, wherein the porous insulating material (2) is formed of ceramic.

4. The plasma jet device of claim 3, wherein the porous insulating material (2) is formed of alumina.

5. The plasma jet device of claim 1, wherein the protection pipe (4) is formed of quartz.

6. A method of manufacturing an electrode (1) to be used in a plasma jet device according to anyone of claims 1 to 5,
**characterized in that** the method comprises:
forming a seed layer on a board;
forming a mold layer on the seed layer;
patterning the mold layer to form a patterned mold layer, wherein the patterned mold layer has a plurality of electrode hole forming portions being separated from each other;
forming an electrode layer on the board where the patterned mold layer, is formed planarizing the patterned mold layer and the electrode layer, and
removing the board, the seed layer, and the patterned mold layer to form the electrode (1) which has a plurality of holes formed therein, the holes corresponding to the electrode hole forming portions.

7. The method of claim 6, wherein, in the forming a seed layer on a board, the seed layer is formed by depositing titanium/gold to a thickness of 500 Å and 2500 Å.

8. The method of claim 7, wherein the titanium/gold is formed in a way of sputtering.

9. The method of claim 6, wherein, in the forming a mold layer on the seed layer, the mold layer is formed by coating with a negative sensitizer.

10. The method of claim 9, wherein a thickness of the mold layer is 100 *µ*m or less.

11. The method of claim 6, wherein, in the patterning the mold layer, the mold layer is patterned in such a way that each of the plurality of electrode hole forming portions is disposed to be separated to one another with the same interval.

12. The method of claim 11, wherein a width of the electrode hole forming portions is 100 *µ*m or less.

13. The method of claim 6, wherein the number of the generated electrode hole forming portions, is 10×10 or more.

14. The method of claim 6, wherein, in the forming an electrode layer, the electrode layer is formed by plating with a nickel layer.

15. The method of claim 14, wherein a thickness of the nickel layer formed on the electrode-forming holes is 70 *µ*m or less.

16. The method of claim 6, wherein, in the planarizing step the patterned mold layer and the electrode layer, the patterned mold layer and the electrode layer are planarized in a way of chemical mechanical polishing (CMP).

17. The method of claim 16, wherein a thickness of the planarized electrode layer is 60 *µ*m or less.

## Patentansprüche

1. Plasmastrahlvorrichtung, aufweisend:
eine Elektrode (1), die als eine Anode verwendet wird, wobei die Elektrode so konfiguriert ist, dass sie Plasma durch Löcher darin ausstößt;
ein Gaseinspritzrohr (5), das von außen Gas einspritzt; und
ein Isoliergehäuse (3);
**dadurch gekennzeichnet, dass** das Gaseinspritzrohr (5) als eine Kathode verwendet wird und die Plasmastrahlvorrichtung ferner aufweist:
ein Schutzrohr (4), das das Gaseinspritzrohr (5) umschließt, um das Gaseinspritzrohr (5) vor dem Äußeren zu schützen; und
ein poröses Isoliermaterial (2), das sich zwischen der Elektrode (1) und dem Gaseinspritzrohr (5) befindet und die Elektrode (1) von dem Gaseinspritzrohr (5) isoliert und eine Mehrzahl an Durchlasslöchern aufweist, die es dem durch das Gaseinspritzrohr (5) eingespritzten Gas ermöglichen, zu der Elektrode übertragen zu werden,
wobei das Isoliergehäuse (3) eines von der Elektrode (1), das poröse Isoliermaterial (2) und das Gaseinspritzrohr (5) umschließt, und
wobei das Isoliergehäuse (3) mit dem porösen Isoliermaterial (2) verbunden ist und die Diffusion einer Entladung verhindert, die zwischen der Elektrode (1) und dem Gaseinspritzrohr (5) stattfindet, um das Plasma zu erzeugen.

2. Plasmastrahlvorrichtung nach Anspruch 1, wobei das Gaseinspritzrohr (5) aus Edelstahl besteht.

3. Plasmastrahlvorrichtung nach Anspruch 1, wobei das poröse Isoliermaterial (2) aus Keramik besteht.

4. Plasmastrahlvorrichtung nach Anspruch 3, wobei das poröse Isoliermaterial (2) aus Tonerde besteht.

5. Plasmastrahlvorrichtung nach Anspruch 1, wobei das Schutzrohr (4) aus Quarz besteht.

6. Verfahren zum Herstellen einer Elektrode (1), die in einer Plasmastrahlvorrichtung nach einem der Ansprüche 1 bis 5 verwendet werden soll,
**dadurch gekennzeichnet, dass** das Verfahren Folgendes aufweist:
Ausbilden einer Keimschicht auf einem Substrat;
Ausbilden einer Formschicht auf der Keimschicht;
Mustern der Formschicht, um eine gemusterte Formschicht auszubilden, wobei die gemusterte Formschicht eine Mehrzahl an Elektrodenlochausbildungsabschnitten aufweist, die voneinander getrennt sind;
Ausbilden einer Elektrodenschicht auf dem Substrat, wo die gemusterte Formschicht ausgebildet ist, und Planarisieren der gemusterten Formschicht und der Elektrodenschicht; und
Entfernen des Substrats, der Keimschicht und der gemusterten Formschicht, um die Elektrode (1) auszubilden, in der eine Mehrzahl an Löchern ausgebildet ist, wobei die Löcher den Elektrodenlochausbildungsabschnitten entsprechen.

7. Verfahren nach Anspruch 6, wobei bei dem Ausbilden einer Keimschicht auf einem Substrat die Keimschicht ausgebildet wird, indem Titan/Gold in einer Dicke von 500 Å und 2500 Å aufgetragen wird.

8. Verfahren nach Anspruch 7, wobei das Titan/Gold durch Sputtern ausgebildet wird.

9. Verfahren nach Anspruch 6, wobei bei dem Ausbilden einer Formschicht auf der Keimschicht die Formschicht durch Beschichten mit einem Negativsensibilisator ausgebildet wird.

10. Verfahren nach Anspruch 9, wobei eine Dicke der Formschicht 100 µm oder weniger beträgt.

11. Verfahren nach Anspruch 6, wobei bei der gemusterten Formschicht die Formschicht so gemustert ist, dass jeder von der Mehrzahl an Elektrodenlochausbildungsabschnitten so angeordnet ist, dass er von den jeweils anderen in demselben Intervall getrennt ist.

12. Verfahren nach Anspruch 11, wobei eine Breite der Elektrodenlochausbildungsabschnitte 100 µm oder weniger beträgt.

13. Verfahren nach Anspruch 6, wobei die Anzahl der erzeugten Elektrodenlochausbildungsabschnitte 10x10 oder mehr beträgt.

14. Verfahren nach Anspruch 6, wobei bei dem Ausbilden einer Elektrodenschicht die Elektrodenschicht durch Plattieren mit einer Nickelschicht ausgebildet wird.

15. Verfahren nach Anspruch 14, wobei eine Dicke der auf den Elektrodenausbildungslöchem ausgebildeten Nickelschicht 70 µm oder weniger beträgt.

16. Verfahren nach Anspruch 6, wobei bei dem Planarisierungsschritt der gemusterten Formschicht und der Elektrodenschicht die gemusterte Formschicht und die Elektrodenschicht durch chemisch-mechanisches Polieren (CMP) planarisiert werden.

17. Verfahren nach Anspruch 16, wobei eine Dicke der planarisierten Elektrodenschicht 60 µm oder weniger beträgt.

## Revendications

1. Dispositif à micro-jets de plasma comprenant :
une électrode (1) utilisée en tant qu'anode, dans lequel l'électrode est configurée pour expulser du plasma à travers des trous dans celle-ci ;
un tuyau d'injection de gaz (5) injectant du gaz à partir de l'extérieur ; et
une enveloppe isolante (3) ;
**caractérisé en ce que** le tuyau d'injection de gaz (5) est utilisé en tant que cathode et **en ce que** le dispositif à micro-jets de plasma comprend en outre :
un tube de protection (4) entourant le tuyau d'injection de gaz (5) pour protéger le tuyau d'injection de gaz (5) contre l'extérieur ; et
un matériau isolant poreux (2) disposé entre ladite électrode (1) et le tuyau d'injection de gaz (5) et isolant l'électrode (1) du tuyau d'injection de gaz (5) et ayant une pluralité de trous de passage pour permettre au gaz injecté par le tuyau d'injection de gaz (5) d'être transféré dans l'électrode,
dans lequel l'enveloppe isolante (3) entoure l'un de l'électrode (1), du matériau isolant poreux (2), et du tuyau d'injection de gaz (5), et
dans lequel l'enveloppe isolante (3) est reliée au matériau isolant poreux (2) et empêche la diffusion d'une décharge se produisant entre l'électrode (1) et le tuyau d'injection de gaz (5) pour générer le plasma.

2. Dispositif à micro-jets de plasma selon la revendication 1, dans lequel le tuyau d'injection de gaz (5) est constitué d'acier inoxydable.

3. Dispositif à micro-jets de plasma selon la revendication 1, dans lequel le matériau isolant poreux (2) est constitué de céramique.

4. Dispositif à micro-jets de plasma selon la revendication 3, dans lequel le matériau isolant poreux (2) est constitué d'alumine.

5. Dispositif à micro-jets de plasma selon la revendication 1, dans lequel le tube de protection (4) est constitué de quartz.

6. Procédé de fabrication d'une électrode (1) à utiliser dans un dispositif à micro-jets de plasma selon l'une quelconque des revendications 1 à 5,
**caractérisé en ce que** le procédé comprend :
la formation d'une couche d'ensemencement sur une planche ;
la formation d'une couche de moule sur la couche d'ensemencement ;
la configuration de la couche de moule pour former une couche de moule configurée, dans lequel la couche de moule configurée comporte une pluralité de parties formant des trous d'électrode qui sont séparées l'une de l'autre ;
la formation d'une couche d'électrode sur la planche où la couche de moule configurée est formée
la planarisation de la couche de moule configurée et de la couche d'électrode ; et
le retrait de la planche, de la couche d'ensemencement, et de la couche de moule configurée pour former l'électrode (1) qui comporte une pluralité de trous formés dans celle-ci, les trous correspondant aux parties formant des trous d'électrode.

7. Procédé selon la revendication 6, dans lequel, lors de la formation d'une couche d'ensemencement sur une planche, la couche d'ensemencement est formée par dépôt de titane/d'or jusqu'à une épaisseur de 500 Å et 2 500 Å.

8. Procédé selon la revendication 7, dans lequel le titane/l'or est formé par un procédé de pulvérisation.

9. Procédé selon la revendication 6, dans lequel, lors de la formation d'une couche de moule sur la couche d'ensemencement, la couche de moule est formée par revêtement avec un sensibilisateur négatif.

10. Procédé selon la revendication 9, dans lequel l'épaisseur de la couche de moule est de 100 µm ou moins.

11. Procédé selon la revendication 6, dans lequel, lors de la configuration de la couche de moule, la couche de moule est configurée de telle manière que chacune de la pluralité de parties formant des trous d'électrode est disposée de manière à être séparée l'une de l'autre par le même intervalle.

12. Procédé selon la revendication 11, dans lequel la largeur des parties formant des trous d'électrode est de 100 µm ou moins.

13. Procédé selon la revendication 6, dans lequel le nombre des parties formant des trous d'électrode générées est de 10 x 10 ou plus.

14. Procédé selon la revendication 6, dans lequel, lors de la formation d'une couche d'électrode, la couche d'électrode est formée par revêtement métallique avec une couche de nickel.

15. Procédé selon la revendication 14, dans lequel l'épaisseur de la couche de nickel formée sur les trous formant électrode est de 70 µm ou moins.

16. Procédé selon la revendication 6, dans lequel, dans l'étape de planarisation de la couche de moule configurée et de la couche d'électrode, la couche de moule configurée et la couche d'électrode sont planarisées suivant un procédé de polissage mécano-chimique (CMP).

17. Procédé selon la revendication 16, dans lequel l'épaisseur de la couche d'électrode planarisée est de 60 µm ou moins.
